Europäisches Patentamt

European Patent Office

Office européen des brevets

(19)

(11) **EP 1 367 637 A1**

(12) **EUROPEAN PATENT APPLICATION**
published in accordance with Art. 158(3) EPC

(43) Date of publication:
03.12.2003 Bulletin 2003/49

(51) Int Cl.⁷: **H01L 21/26**

(86) International application number:
**PCT/JP02/01380**

(21) Application number: 02712428.8

(22) Date of filing: 18.02.2002

(87) International publication number:
**WO 02/065521 (22.08.2002 Gazette 2002/34)**

(84) Designated Contracting States:
**AT BE CH CY DE DK ES FI FR GB GR IE IT LI LU MC NL PT SE TR**

(30) Priority: 16.02.2001 JP 2001040570
11.06.2001 JP 2001175354

(71) Applicant: **TOKYO ELECTRON LIMITED**
**Minato-ku, Tokyo 107-8481 (JP)**

(72) Inventors:
• **KASAI, Shigeru, c/o Tokyo Electron AT Limited**
  **Nirasaki-shi, Yamanashi 407-0192 (JP)**
• **MIYASHITA, Hiroyuki,**
  **c/o Tokyo Electron AT Limited**
  **Nirasaki-shi, Yamanashi 407-0192 (JP)**

(74) Representative: **Liesegang, Eva**
**Forrester & Boehmert,**
**Pettenkoferstrasse 20-22**
**80336 München (DE)**

(54) **SHEET-TYPE TREATING DEVICE**

(57) This invention relates to a thermal processing method including: a placing step of placing an object to be processed onto a stage arranged in a processing container that can be vacuumed; and a heating step of heating the object to be processed to a predetermined temperature. The object to be processed is heated under a state in which a temperature distribution is maintained in such a manner that a temperature at a central portion of the object to be processed is high while a temperature at a peripheral portion of the object to be processed is low, during at least a part of the heating step.

FIG. I

**Description**

Field of the Invention

This invention relates to a thermal processing unit that can carry out a thermal process such as a film-forming process or an annealing process, to semiconductor wafers or the like one by one.

Background Art

In general, in order to manufacture a desired semiconductor integrated circuit, various thermal processes including a film-forming process, an etching process, an oxidation-diffusion process, an annealing process or the like are carried out repeatedly to a substrate such as a semiconductor wafer.

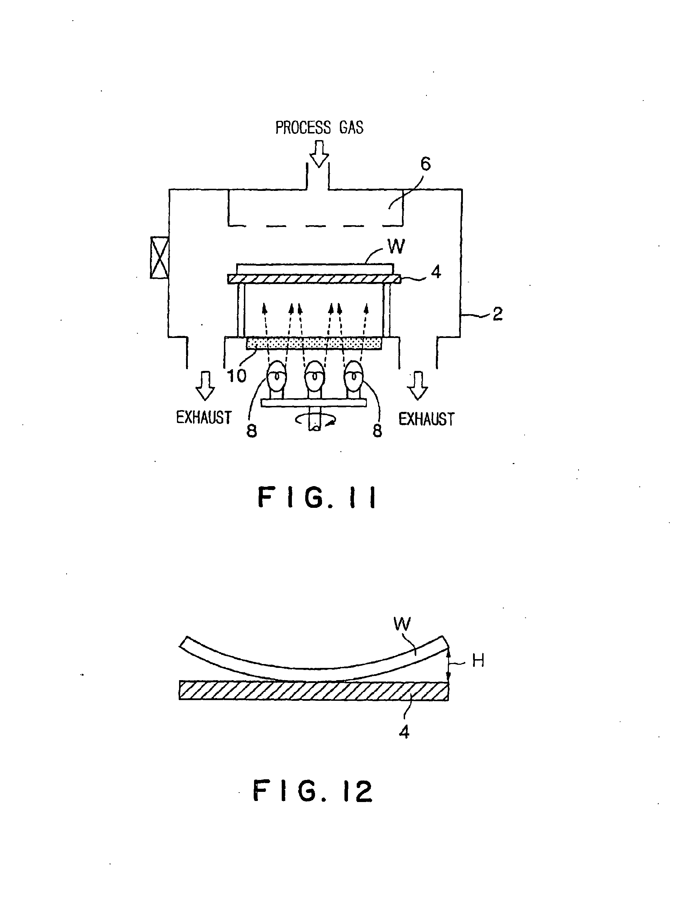

An example of single wafer thermal processing unit for conducting the above thermal processes is explained. Fig. 11 is a schematic structural view showing an example of conventional thermal processing unit. Fig. 12 is a schematic view showing a state wherein a semiconductor wafer placed on a stage cocks up (cambers).

The thermal processing unit shown in Fig. 11 has a processing container 2 that can be vacuumed. A stage 4 onto which a semiconductor wafer W is placed is arranged in the processing container 2. A showerhead 6 for introducing a process gas is arranged at a ceiling part of the processing container 2. A plurality of heating lamps 8 are provided below a bottom part of the processing container 2 as a heating unit. Heat rays emitted from the heating lamps 8 are projected on the stage 4 through a transmission window 10, for example made of quartz, provided at the bottom part of the processing container 2. Thus, the wafer W is heated, so that a desired thermal process can be conducted at a predetermined temperature.

Summary of the Invention

In processes to a semiconductor wafer, in order to enhance productivity i.e. throughput, the wafer temperature is raised to a predetermined process temperature as fast as possible. If the diameter of a wafer is relatively small, for example six inches, rapid heating generates not so serious problems. However, as the size of a wafer is enlarged to 8 inches or 12 inches, as shown in Fig. 12, a peripheral portion of the semiconductor wafer W itself cocks up to be deformed, while heated. The cockup is caused by that an amount of thermal expansion on a reverse side of the wafer contacting with the stage 4 becomes larger than that on an upper side of the wafer. Such cockup phenomenon of the wafer is remarkably great if the wafer is a 12-inch (30 cm) wafer. The cockup height H of the peripheral portion may reach about 3 mm, although it is dependent on the process temperature.

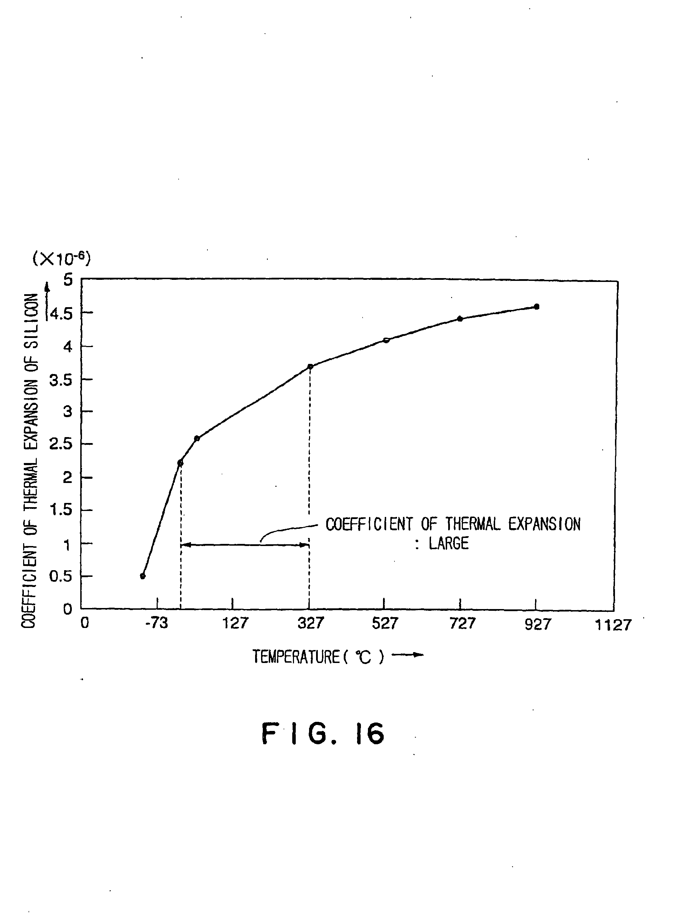

As shown by a graph of coefficients of thermal expansion of a Si wafer in Fig. 16, the coefficients of thermal expansion from the room temperature until for example about 327 °C are significantly larger than those in a temperature region over the above range. This is the reason why the wafer cambers while it is heated.

If a wafer cambers, a conveyance error may be generated while the wafer is conveyed. Alternatively, if a thin film is deposited under that state, film-stress becomes so great that film-peeling can be easily generated.

This invention is intended to solve the above problems. The object of this invention is to provide a thermal processing method and a thermal processing unit that can prevent generation of cambering deformation of an object to be processed, while the object to be processed is heated, without lowering throughput.

This invention is a thermal processing method comprising: a placing step of placing an object to be processed onto a stage arranged in a processing container that can be vacuumed; and a heating step of heating the object to be processed to a predetermined temperature; wherein the object to be processed is heated under a state in which a temperature distribution is maintained in such a manner that a temperature at a central portion of the object to be processed is high while a temperature at a peripheral portion of the object to be processed is low, during at least a part of the heating step.

According to the invention, since the object to be processed is heated under the state in which a temperature distribution is maintained in such a manner that a temperature at a central portion of the object to be processed is high while a temperature at a peripheral portion of the object to be processed is low, it can be prevented that cambering deformation of the object to be processed is generated. Thus, a peeling-off of a thin film and/or a conveyance error of an object to be processed can be prevented.

Preferably, the object to be processed is heated with a temperature-rising speed that is slower than a heat-transferring speed from the central portion to the peripheral portion of the object to be processed, during at least a part of the heating step.

In addition, preferably, the predetermined temperature is a cockup-safe temperature at which a coefficient of thermal expansion of the object to be processed is so low that it is difficult for the object to be processed to cock up.

In addition, this invention is a thermal processing method comprising: a placing step of placing an object to be processed onto a stage arranged in a processing container that can be vacuumed; and a heating step of heating the object to be processed to a predetermined temperature; wherein a pressure in the processing container is set equal to or lower than a viscous flow, during at least a part of the heating step.

According to the invention, since the pressure in the processing container is set equal to or lower than a viscous flow while the object to be processed is heated, radiation is aprincipal in heat transfer, so that a heat-transferring speed from the stage to the object to be processed can be slow. Thus , it can be prevented that cambering deformation of the object to be processed is generated. Thus, a peeling-off of a thin film and/or a conveyance error of an object to be processed can be prevented.

Preferably, the pressure equal to or lower than a viscous flow corresponds to a pressure not more than 133 Pa (1 Torr).

In addition, preferably, the predetermined temperature is a cockup-safe temperature at which a coefficient of thermal expansion of the object to be processed is so low that it is difficult for the object to be processed to cock up.

In addition, this invention is a thermal processing unit comprising: a processing container that can be vacuumed; a stage arranged in the processing container, on which an object to be processed is placed; a plurality of zone-heating parts that independently heat respective concentrically divided zones of the object to be processed; an electric-power supplying unit that supplies electric power to each of the plurality of zone-heating parts; a temperature measuring unit provided correspondingly to at least one of the zones of the object to be processed; and an electric-power controlling unit that controls the electric-power supplying unit based on a value detected by the temperature measuring unit in such a manner that the object to be processed is heated to a predetermined temperature under a state in which a temperature distribution is maintained wherein a temperature at a central portion of the object to be processed is high while a temperature at a peripheral portion of the object to be processed is low.

Alternatively, this invention is a thermal processing unit comprising: a processing container that can be vacuumed; a stage arranged in the processing container, on which an object to be processed is placed; a heating part that heats the object to be processed in such a manner that a predetermined temperature distribution is formed; an electric-power supplying unit that supplies electric power to the heating part; and an electric-power controlling unit that controls the electric-power supplying unit in such a manner that the object to be processed is heated to a predetermined temperature under a state in which a temperature distribution is maintained wherein a temperature at a central portion of the object to be processed is high while a temperature at a peripheral portion of the object to be processed is low.

Alternatively, this invention is a thermal processing unit comprising: a processing container that can be vacuumed; a stage arranged in the processing container, on which an object to be processed is placed; a heating part that heats the object to be processed in such a manner that a concentric temperature distribution is formed; an electric-power supplying unit that supplies electric power to the heating part; a temperature. measuring unit provided correspondingly to at least one position of the object to be processed; and an electric-power controlling unit that controls the electric-power supplying unit based on a value detected by the temperature measuring unit in such a manner that the object to be processed is heated to a.predetermined temperature under a state in which a temperature distribution is maintained wherein a temperature at a central portion of the object to be processed is high while a temperature at a peripheral portion of the object to be processed is low.

Alternatively, this invention is a thermal processing unit comprising: a processing container that can be vacuumed; a stage arranged in the processing container, on which an object to be processed is placed; a plurality of zone-heating parts that independently heat respective concentrically divided zones of the object to be processed; an electric-power supplying unit that supplies electric power to each of the plurality of zone-heating parts; a power detecting unit that detects respective power supplied from the electric-power supplying unit to the respective zone-heating parts or respective power emitted from the respective zone-heating parts; and an electric-power controlling unit that controls the electric-power supplying unit based on a value detected by the power detecting unit in such a manner that the object to be processed is heated to a predetermined temperature under a state in which a temperature distribution is maintained wherein a temperature at a central portion of the object to be processed is high while a temperature at a peripheral portion of the object to be processed is low.

Alternatively, this invention is a thermal processing unit comprising: a processing container that can be vacuumed; a stage arranged in the processing container, on which an object to be processed is placed; a heating part that heats the object to be processed in such a manner that a concentric temperature distribution is formed; an electric-power supplying unit that supplies electric power to the heating part; a power detecting unit that detects power supplied from the electric-power supplying unit to the heating part or power emitted from the heating part; and an electric-power controlling unit that controls the electric-power supplying unit based on a value detected by the power detecting unit in such a manner that the object to be processed is heated to a predetermined temperature under a state in which a temperature distribution is maintained wherein a temperature at a central portion of the object to be processed is high while a temperature at a peripheral portion of the object to be processed is low.

Preferably, the power detecting unit includes at least one of a current detector, a voltage detector and a light-quantity detector.

In addition, preferably, the predetermined temperature is a cockup-safe temperature at which a coefficient of thermal expansion of the object to be processed is so low that it is difficult for the object to be processed to cock up. In particular, preferably, the predetermined temperature is a temperature not lower than 300 °C.

In addition, preferably, the electric-power controlling unit can control the electric-power supplying unit in such a manner that the object to be processed is heated with a temperature-rising speed that is slower than a heat-transferring speed from the central portion to the peripheral portion of the object to be processed.

In addition, preferably, the electric-power controlling unit includes a limiter part for limiting an actuating variable.

In the case, more preferably, the limiter part is adapted to conduct a limiting process to the actuating variable with a fixed limiter-constant in such amanner that the actuating variable is not saturated while the object to be processed is heated. Alternatively, the limiter part is adapted to conduct a limiting process to the actuating variable with a variable limiter-value in such a manner that the actuating variable is not saturated while the object to be processed is heated.

In addition, preferably, the electric-power controlling unit includes a plurality of limiter parts for limiting actuating variables to the respective zone-heating parts; and when an actuating variable to a zone-heating part is saturated, the respective limiter parts are adapted to conduct a limiting process to actuating variables to the other zone-heating parts. In the case, more preferably, a limiter-value used for the limiting process is determined based on a ratio between an actuating variable to the saturated zone-heating part and the saturated actuating variable to the saturated zone-heating part.

Brief Description of the Drawings

Fig. 1 is a sectional view showing an embodiment of a processing unit according to the present invention;

Fig. 2 is a schematic view showing a control system of a heating unit that heats a stage;

Fig. 3 is a schematic view showing an example of shift of a temperature distribution while the object to be processed is heated;

Fig. 4 is a block diagram showing an example of a control system of an electric-power controlling unit in a variant of the processing unit according to the present invention;

Fig. 5 is a block diagram showing an example of a control system of an electric-power controlling unit in another variant of the processing unit according to the present invention;

Fig. 6 is a view showing a state wherein current detectors are provided for detecting output currents from respective electric-power supplying parts as a power detecting unit;

Fig. 7 is a view showing a state wherein voltage detectors are provided for detecting output voltages from respective electric-power supplying parts as a power detecting unit;

Fig. 8 is a view showing a state wherein light-quantity detectors are provided correspondingly to respective zones for detecting light-quantities of heat rays from respective heating lamps as a power detecting unit;

Fig. 9 is a view showing heat-transferring states while the object to be processed is heated, according to a method of prior art and a method of the present invention;

Fig. 10 is a plan view showing a heating lamp as a variant of the heating unit;

Fig. 11 is a schematic structural view showing an example of conventional thermal processing unit;

Fig. 12 is a schematic view showing a state wherein a semiconductor wafer placed on a stage cocks up;

Fig. 13 is a block diagram showing an example of a control system of an electric-power controlling unit in another variant of the processing unit according to the present invention;

Fig. 14 is a block diagram showing an example of a control system of an electric-power controlling unit in another variant of the processing unit according to the present invention;

Fig. 15 is a block diagram showing an example of a control system of an electric-power controlling unit in another variant of the processing unit according to the present invention;

Fig. 16 is a graph showing a relationship between coefficients of thermal expansion of silicon and temperatures;

Fig. 17 is a view showing a state wherein light-quantity detectors are provided correspondingly to respective zones for detecting light-quantities of reflected rays or the like as a power detecting unit; and

Fig. 18 is a plan view showing a variant of the heating lamp of Fig. 10.

Description of the Preferred Embodiment

Hereinafter, an embodiment of a processing unit according to the present invention is described in detail with reference to attached drawings.

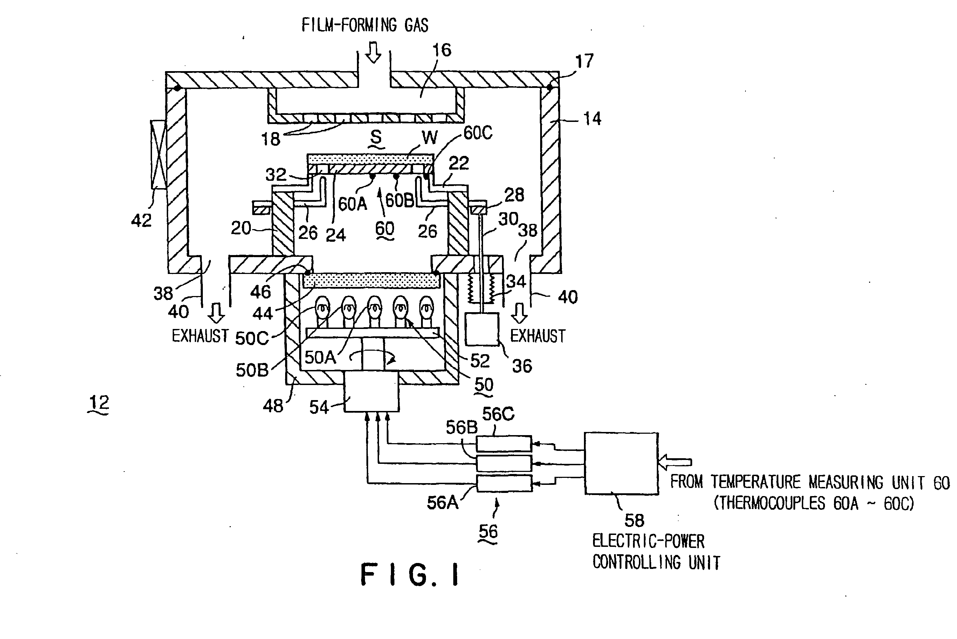

Fig. 1 is a sectional view showing the embodiment of a processing unit according to the present invention.

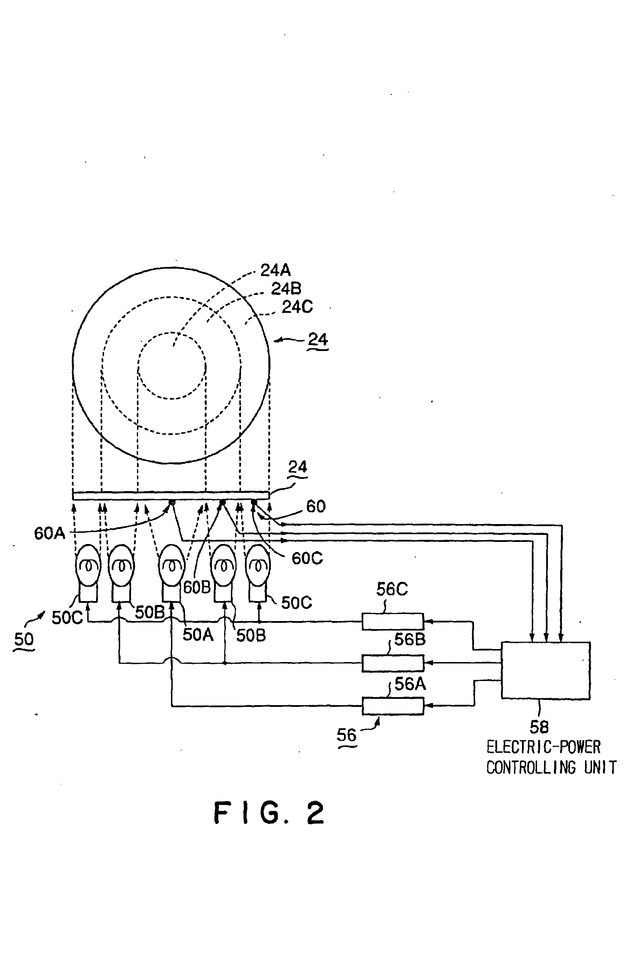

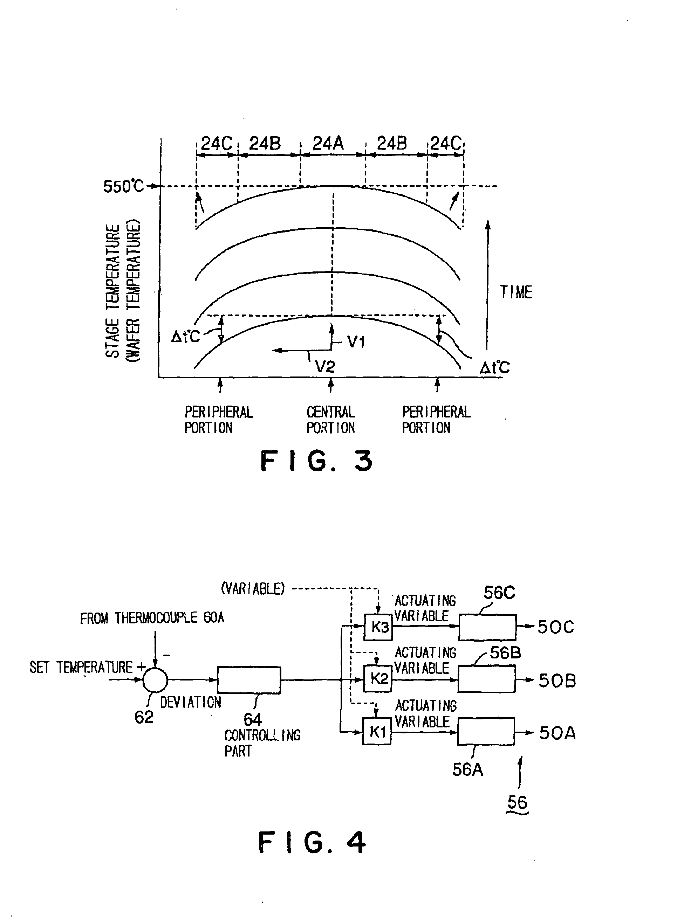

Fig. 2 is a schematic view showing a control system of a heating unit that heats a stage. Fig. 3 is a schematic view showing an example of shiftof a temperature distribution while the object to be processed is heated. Herein, a single wafer film-forming unit is explained as an example of a processing unit.

As shown in Fig. 1, a film-forming unit 12 has a processing container 14, for example having a substantially cylindrical shape and made of aluminum. A showerhead part 16 is provided at a ceiling part in the processing container 14 via a sealing member 17 such as an O-ring. A large number of gas-jetting holes 18 are provided at a lower surface of the showerhead part 16. Thus, process gases such as various film-forming gases, whose flow rates are controlled, are adapted to be jetted from the large number of gas-jetting holes 18 toward a processing space S.

In the processing container 14, a cylindrical reflector 20 stands on a bottom part of the processing container. A stage 24 for placing a semiconductor wafer W as an object to be processed thereon is arranged above the reflector 20 for example via three L-shaped holding members 22 (only two are shown in Fig. 1). The reflector 20 is made of aluminum. The holding members 22 are made of a heat transmissive material such as quartz. The stage 24 has a thickness of about 1 mm, and is made of a carbon material, a ceramic such as AlN, or the like.

A plurality of, for example three, L-shaped lifter pins 26 (only two are shown in the example) stand upward below the stage 24. Each lifter pin 26 has a base portion, which extends outwardly through the reflector 20 in a vertically movable manner and is commonly connected to a ring member 28. The ring member 28 is vertically movable by means of a pushing-up rod 30 that extends through the bottompart of the processing container. Thus, tip ends of the lifter pins 26 can be inserted into through lifter-pin holes 32 provided in the stage 24, in order to lift up the wafer W.

An extendable bellows 34 is provided between a lower part of the pushing-up rod 30 and a lower surface of the bottom part of the processing container, in order to maintain airtightness in the processing container 14. A lower end of the pushing-rod 30 is connected to an actuator 36.

A discharging port 38 is provided at a peripheral portion of the bottom part of the processing container 14. A discharging passage 40 connected to a vacuum pump not shown is connected to the discharging port 38. Thus, a predetermined vacuum level can be maintained in the processing container 14. A gate-valve 42, which is opened and closed when the wafer is conveyed into and from the processing container 14, is provided at a side wall of the processing container 14.

A transmission window 44 made of a heat transmissive material such as quartz is hermetically provided at the bottom part of the processing container just below the stage 24 via a sealing member 46 such as an O-ring. Abox-like heating room 48 is arranged below the transmission window 44 so as to surround the transmission window 44. In the heating room 48, a heating unit 50, for example consisting of a plurality of heating lamps, is attached on a rotating table 52 that also serves as a reflecting mirror. The rotating table 52 can be rotated by a rotation motor 54 provided at a bottom part of the heating room 48, via a rotational shaft. Heat rays emitted from the heating unit 50 reach the lower surface of the stage 24 through the transmission window 44. Thus, the stage 24 can be heated.

Then, the heating unit 50 is connected to an electric-power supplying unit 56 for supplying electric power thereto. The electric-power supplying unit 56 is controlled by an electric-power controlling unit 58 such as a micro computer or the like.

In addition, as shown in Figs. 1 and 2, a temperature measuring unit 60 is provided on the reverse side of the stage 24, for measuring a temperature at that location. For example, the temperature measuring unit 60 consists of one or more thermocouples. The value measured by the temperature measuring unit 60 is adapted to be supplied to the above electric-power controlling unit 58.

Herein, the stage 24 is divided into a plurality of, for example three, concentric zones 24A, 24B and 24C. Thermocouples 60A, 60B and 60C as a temperature measuring unit 60 are respectively arranged correspondingly to the respective zones 24A to 24C.

The plurality of heating lamps forming the heating unit 50 are divided into three heating-lamp groups (zone-heating parts) 50A, 508 and 50C, correspondingly to the respective zones 24A to 24C of the stage 24. Thus, mainly, the inside zone 24A is illuminated with the inside heating-lamp 50A, the middle zone 24B is illuminated with the middle heating-lamps 50B and the outside zone 24C is illuminated with the outside heating-lamps 50C, respectively. The electric-power supplying unit 56 has three electric-power supplying parts 56A, 56B and 56C, which are respectively connected to the three heating-lamp groups 50A to 50C. Thus, supplied electric power can be independently controlled for each of the heating-lamp groups 50A to 50C. Then, as a feature of the present invention, by means of the electric-power controlling unit 58, the semiconductor wafer W can be heated to a predetermined temperature under a state wherein a temperature distribution is maintained in such a manner that a temperature of a central portion of the wafer W is high while a temperature of a peripheral portion of the wafer W is low.

Next, a method of the present invention conducted by using the above structured unit is explained.

At first, the gate valve 42 provided at a side wall of the processing container 14 is opened, and a wafer W is conveyed into the processing container 14 by a conveying arm not shown. On the other hand, the lifter pins 26 are pushed up via the pushing-up rod 30, so that the lifter pins 26 protrude from the stage 24. The wafer W is received onto the protruding lifter pins 26. Then, the lifter pins 26 drop down, so that the wafer W is placed on the stage 24.

Then, predetermined film-forming gases as process gases are supplied from process-gas sources not shown to the showerhead part 16 at respective predetermined flow rates. The film-forming gases are supplied substantially uniformly from the gas-jetting holes 18 into the processing container 14. At the same time, the inside atmosphere is discharged through the discharging port 38, so that the inside of the processing container 14 is set at a predetermined vacuum level, for example of about 600 Pa. In addition, the respective heating-lamp groups 50A to 50C of the heating unit 50 disposed below the stage 24 are rotated by the rotation motor 54 and driven to emit thermal energy.

Emitted heat rays reach the reverse side of the stage 24 through the transmission window 44 , and heat there. As described above, the stage 24 has a thickness of about 1 mm, that is, the stage 24 is very thin. Thus, the stage 24 is rapidly heated. Therefore, the wafer W placed thereon is also rapidly heated to a predetermined temperature, for example about 550 °C. The supplied film-forming gases generate a predetermined chemical reaction, so that a thin film is deposited on the whole surface of the wafer.

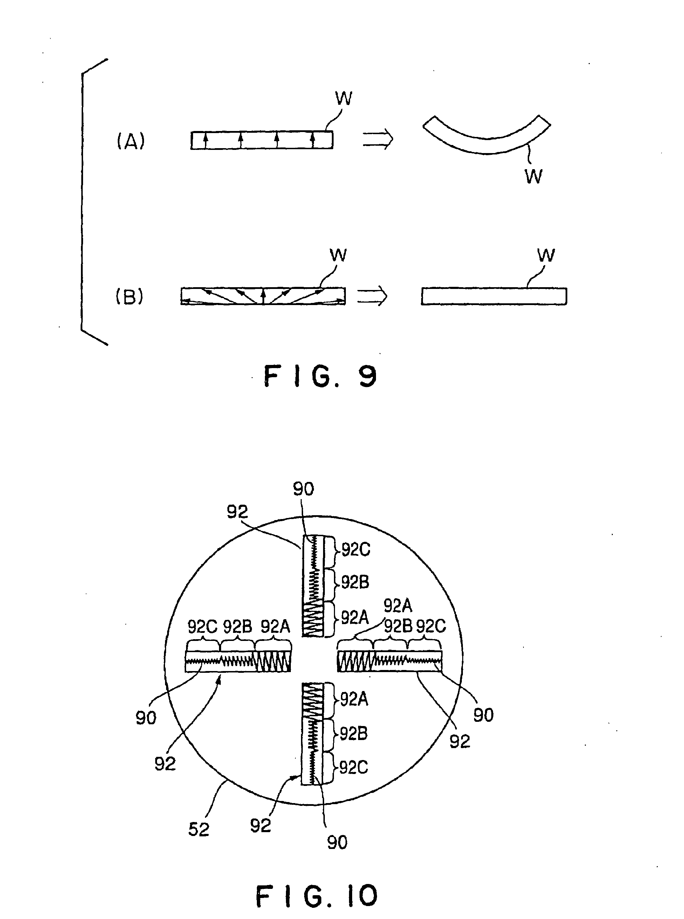

Herein, when the semiconductor wafer W is heated according to a conventional method, the whole surface of the wafer is heated with a uniform temperature. Thus, as shown in Fig. 9(A), the heat transfers from the reverse surface of the wafer to the front (upper) surface of the wafer, so that a temperature difference between the reverse surface and the front surface becomes larger.

On the other hand, when the semiconductor wafer W is heated according to a method of the present invention, the wafer is heated with a temperature distribution in such amanner that a temperature of a central portion of the wafer is high and a temperature of a peripheral portion of the wafer is low. Thus, as shown in Fig. 9 (B) , regarding heat transfer, a component from the reverse surface of the wafer toward the front surface thereof and a component from the center of the wafer toward a peripheral edge thereof are generated, so that a temperature difference between the reverse surface and the front surface becomes smaller.

More specifically, in the present invention, it is preferable that the wafer W is heated to a predetermined temperature with a temperature distribution as shown in Fig. 3.

That is, values detected by the respective thermocouples 60A to 60C, which are provided correspondingly to the respective zones 24A to 24C of the stage 24 , are inputted to the electric-power controlling unit 58. Based on the detected values, the respective electric-power supplying parts 56A to 56C of the electric-power supplying unit 56 are controlled. Thus, supplied electric energy is determined for each of the heating-lamp groups 50A to 50C of the respective zones. At that time, in order to maintain the temperature distribution of the stage 24 as shown in Fig. 3, the electric energy supplied to the respective heating-lamp groups 50A to 50C are inevitably controlled by a feedback loop.

In Fig. 3, a lapse of time is depicted from a lower side toward an upper side. A shift of the temperature distribution for each predetermined period is shown in Fig. 3. As shown in Fig. 3, a temperature difference between a central portion of the stage 24 and a peripheral portion thereof is substantially Δt °C, and a convex temperature distribution is formed wherein a temperature of the central portion is high. While the temperature distribution is maintained, the temperature of the whole wafer is raised. When the temperature of the central portion of the wafer substantially reaches 550 °C, which is a set value, a heating operation only for the peripheral portion is continued more only for a certain time. Thus, the temperature of the whole wafer W is set at 550 °C, which is a set value.

In this case, the temperature difference Δt °C is for example about 10 to 30 °C, when the wafer W is of 300 mm size (12 inches), although it depends on a diameter of the wafer W and/or a set value of the target temperature.

In addition, in the above heating step, after the temperature of the central portion of the wafer reaches a cockup-safe temperature, for example 300 to 350 °C, the wafer can be heated with a uniform temperature distribution (not convex but flat temperature distribution) . The reason is that a coefficient of thermal expansion of the material forming the wafer is smaller in a temperature region over the cockup-safe temperature than in a temperature region around a room temperature, so that a stress of a cockup deformation can be eased in the temperature region over the cockup-safe temperature. In the case, the temperature-rising speed of the wafer can be a little enhanced. Herein, the cockup-safe temperature means a temperature area in which a cockup (cambering) deformation is not generated in the wafer W even if the wafer W is heated with a flat temperature distribution.

In addition, the important point is that the temperature-rising speed V1 of the semiconductor wafer W is set to be slower than a heat-transferring speed V2 from the central portion of the wafer to the peripheral portion thereof, as shown in Fig. 3. If the temperature-rising speed V1 is too much faster than the heat-transferring speed V2, aheat-transferring component from the reverse surface toward the front surface of the wafer W is increased. Thus, a thermal-expansion difference between the front surface and the reverse surface of the wafer W becomes larger, so that a cockup (cambering) deformation of the wafer may be generated. However, like the embodiment, if the temperature difference between the central portion of the wafer W and the peripheral portion thereof is maintained at about Δt °C and the temperature-rising speed V1 is set to be slower than the heat-transferring speed V2, the wafer W can be heated without generating a cockup (cambering) deformation in the wafer and without lowering a throughput thereof.

Herein, with a view to prevent breakage of the stage caused by a thermal stress and to prevent cambering deformation of the wafer, it is preferable that the temperature Δt °C is within the range of 10 °C to 30 °C.

In the case, the temperature-rising speed V1 of the wafer W may be set to for example about 10 °C/sec as a speed so as not to generate cambering deformation of the wafer and so as not to substantially lower the throughput.

While the wafer is heated, the pressure in the processing container 14 is set to about 600 Pa, which is higher than the process pressure as described above, in order to maintain a relatively good thermal conductivity between the wafer W and the stage 24. However, this invention is not limited to this manner.

In addition, in the above embodiment, each heating-lamp group is independently arranged for each of the zones of the stage 24. However, this invention is not limited to this manner. If a desired temperature distribution can be obtained, it is unnecessary to provide heating lamps for each of the zones. That is, the number of provided heating lamps may be smaller than the number of zones. For example, only one heating lamp may be arranged.

In addition, in the above embodiment, the thermocouples 60A to 60C are respectively provided for the respective zones 24A to 24C of the stage 24 . However, this invention is not limited to this manner. For example, in order to measure a temperature distribution, only two thermocouples can be provided. For example, the thermocouples 60A and 60C may be respectively arranged for the inside zone 24A and the outside zone 24C. In the case, as a temperature of the middle zone 24B for using the temperature control, for example a median of values detected by the two thermocouples 60A and 60C can be used.

In addition, if only one thermocouple is provided for a zone, regarding the other zones, in order to generate the temperature distribution as shown in Fig. 3, electric power is supplied to the respective zones according to predetermined rates. Fig. 4 is a block diagram showing an example of a control system of the electric-power controlling unit 58 that is controlled according to such a method. In the case, the thermocouple 60A is provided only for the inside zone 24A and no thermocouple are provided for the other zones 24B and 24C.

In Fig. 4, a comparing part 62 compares a value measured by the thermocouple 60A and a value of the set temperature, and thus outputs a deviation. The controlling part 64 determines a controlled variable based on the deviation from the comparing part 62. Then, an actuating variable outputted from the controlling part 64 is multiplied by variable gain constants K1, K2 and K3 corresponding to the respective zones. The respective results of the multiplication are outputted to the respective electric-power supplying parts 56A to 56C. Herein, for example, if the gain constant K1 corresponding to the inside zone 24A is set to "1", the other gain constants K2 and K3 are respectively set to values not larger than "1" in advance in order to form the temperature distribution as shown in Fig. 3 and described above. If a value detected by the thermocouple 60A reaches the set temperature as the target temperature, the other gain constants K2 and K3 are also sequentially changed toward "1". Thus, finally, the temperature of the whole surface of the wafer can be maintained to the set temperature.

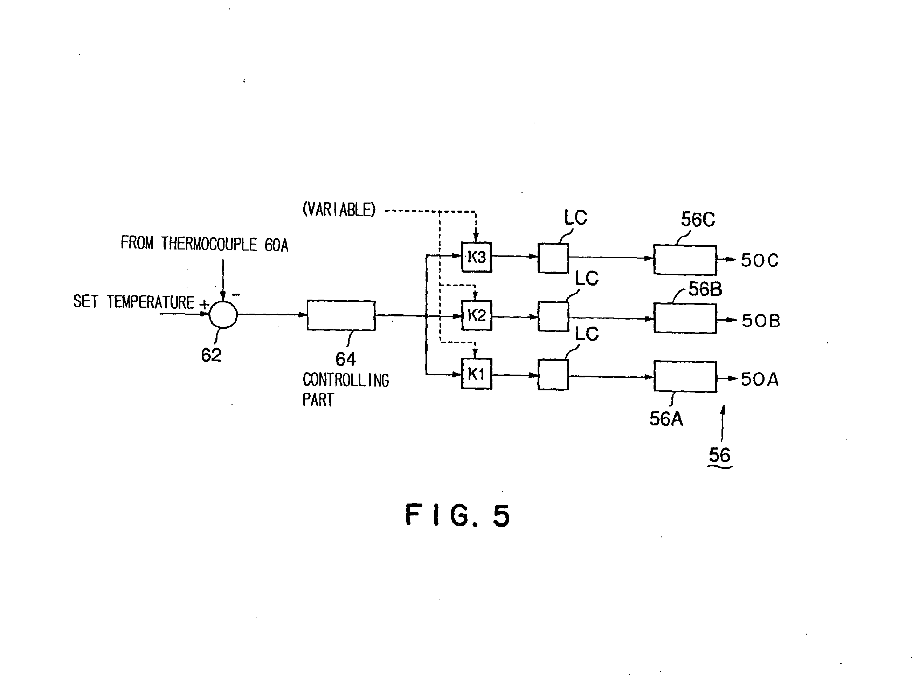

In addition, as shown in Fig. 5, the outputted actuating variables of the results of the multiplication by the respective gain constants K1, K2 and K3 may be commonly multiplied by a positive number smaller than "1", such as a limiting constant LC of "0.7" or the like (that is fixed) , in order not to saturate the actuating variables while the wafer is heated. This is effective in preventing that outputs from amplifiers of the electric-power supplying parts 56A to 56C are saturated. Alternatively, in the case shown in Fig. 5, regarding an actuating variable U1 inputted for the gain constant K1, if the outputted actuating variable is saturated to $U1_{sus}$, a saturating rate $K1 = U1_{sus}/U1$ is calculated, and the other actuating variables for the other heating-lamp groups SOB and 50C may be multiplied by the saturating rate K1 as a limiting value LC (that is valuable).

In addition, in the case of the unit shown in Fig. 2, the respective temperatures of the zones 24A to 24C can be directly measured. However, this invention is not limited to this manner. For example, a power detecting unit, which detects respective power supplied to the respective zone-heating parts (heating-lamp groups) 50A to 50C corresponding to the respective zones 24A to 24C or respective power emitted from the respective zones 24A to 24C, may be provided and the electric power may be controlled based on values detected by the power detecting unit.

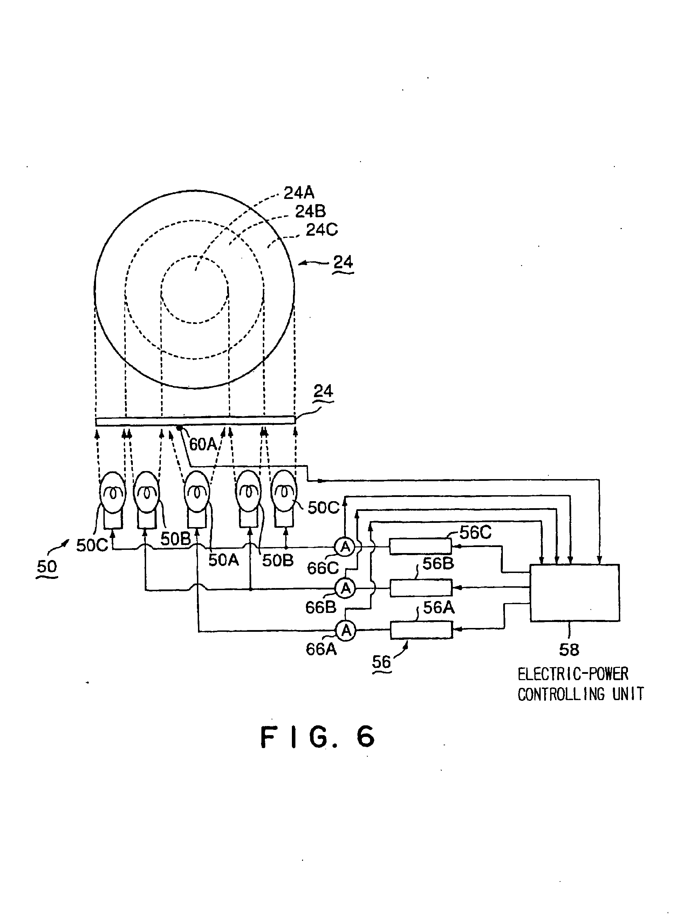

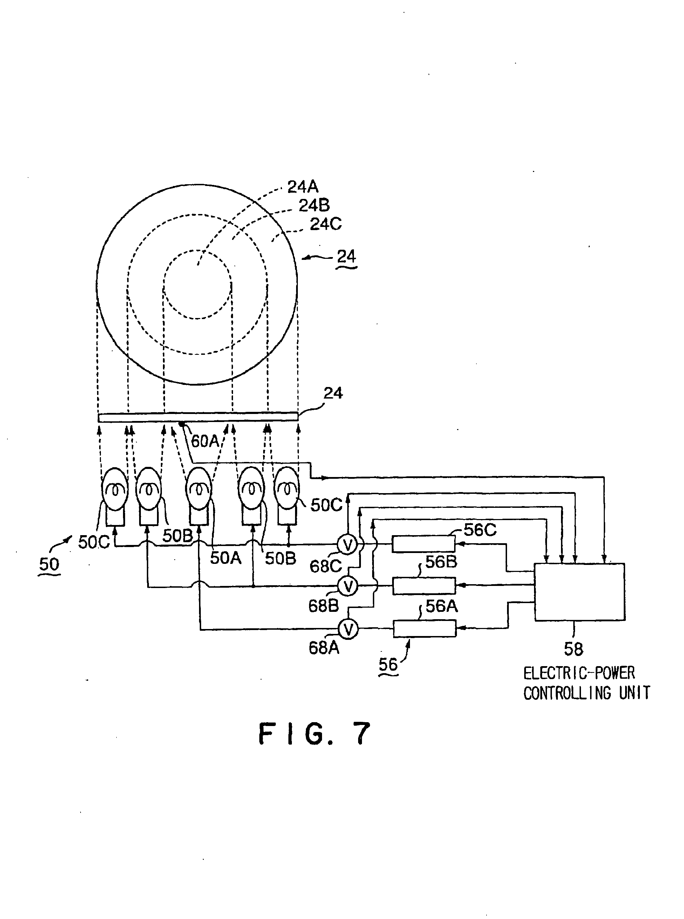

Fig. 6 shows a case wherein current detectors 66A, 66B and 66C are provided for detecting output currents from the respective electric-power supplying parts 56A to 56C as a power detecting unit. Fig. 7 shows a case wherein voltage detectors 68A, 68B and 68C are provided for detecting output voltages from the respective electric-power supplying parts 56A to 56C as a power detecting unit.

Then, the electric-power controlling unit 58 controls electric power supplied to the respective heating-lamp groups 50A to 50C, based on the detected output currents or the detected output voltages.

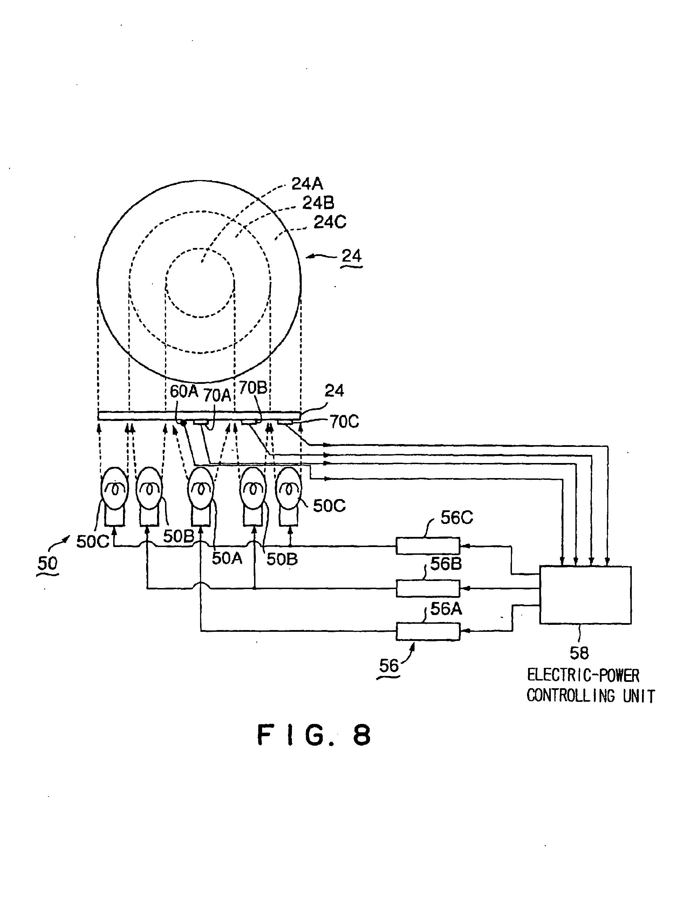

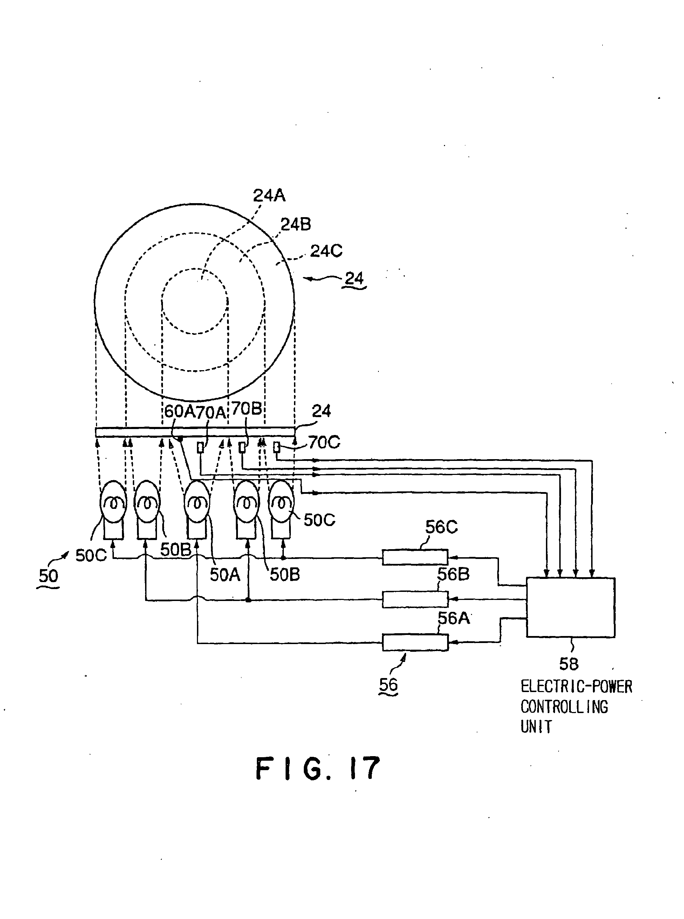

In addition, as shown in Fig.8, if light-quantity detectors 70A, 70B and 70C, which have optical fibers or the like extending to the stage correspondingly to the respective zones 24A to 24C, are provided as a power detecting unit, light-quantities of heat rays from the respective heating lamps 50A to 50C can be detected. Alternatively, as shown in Fig. 17, the light-quantity detectors 70A, 70B and 70C may detect light-quantities of reflected rays from the respective zones 24A to 24C, light-quantities of infrared rays emitted from the respective zones 24A to 24C, or the like. In these cases, the electric-power controlling unit 58 controls electric power supplied to the respective heating-lamp groups 50A to 50C, based on values detectedby the light-quantity detectors 70A to 70C.

Thus, in the respective units shown in Figs. 6 to 8 as well, by heating the wafer while maintaining the temperature difference between the central portion of the wafer W and the peripheral portion thereof at about Δt °C, the wafer can be heated without generating a cockup (cambering) deformation in the wafer and without lowering a throughput thereof.

Herein, in order to directly measure the temperature of the stage 24, it is preferable that at least one thermocouple is provided. In Figs. 6 to 8, the thermocouple 60A corresponding to the inside zone 24A is provided.

In the above embodiment, in order to obtain the temperature distribution as shown in Fig.3 in the stage 24, respective electric-power supplied to the respective zones 24A to 24C is controlled. In addition to the operation or instead of the operation, the pressure in the processing container 14 may be reduced to a pressure equal to or lower than a viscous flow, while the wafer is heated. Actually, the pressure equal to or lower than a viscous flow means a pressure not more than 133 Pa (1 Torr), which corresponds to a pressure in a region of a molecular flow.

Thus, regarding the heat transfer between the stage 24 and the wafer W, heat conduction and heat radiation become dominant, and the heat transfer by convection becomes few. Thus, the whole heat transfer between them is a little inhibited. As a result, the temperature-rising speed of the wafer itself is inhibited, that is, becomes slower, and a heat-transferring component from the center of the wafer toward the peripheral edge thereof is increased, so that the temperature difference between the front surface of the wafer and the reverse surface thereof becomes smaller. Thus, it can be prevented that a cambering deformation is generated in the wafer itself.

In addition, in the above embodiment, as a heating unit, the heating lamps are used, which are point light sources. However, this invention is not limited to this manner. For example, a line-light-source lamp, which may be formed by coiling a filament or the like, may be used. In the case, for example as shown in Fig. 10, a plurality of, for example four, line-like heating lamps 92, each of which is formed by coiling a filament 90, maybe arranged radially. Herein, the filament 90 is coiled in such a manner that it forms a high-density portion 92A, a middle-density portion 92B and a low-density portion 92C in that order. If the respective line-like heating lamps 92 are arranged in such a manner that the high-density portions 92A are located nearer to the center of the rotating table 52, the zone-like temperature distribution as shown in Fig. 3 can be obtained.

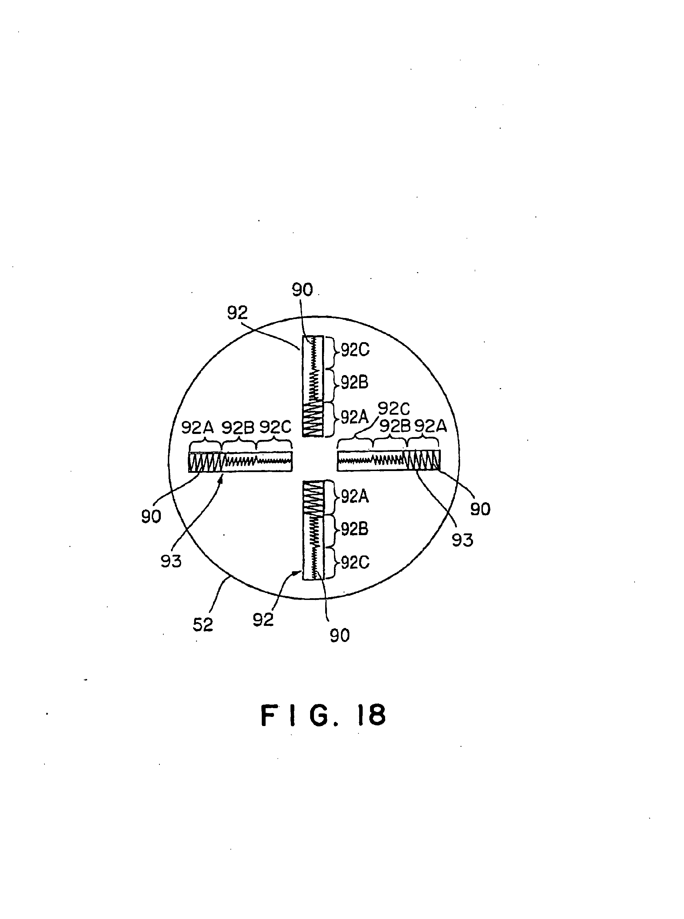

Furthermore, for example as shown in Fig. 18, a plurality of, for example four, line-like heating lamps 92 and 93, each of which is formed by coiling a filament 90 , maybe arranged radially. The respective line-like heating lamps 92 may be arranged in such a manner that the high-density portions 92A are located nearer to the center of the rotating table 52, while the respective line-like heating lamps 93 may be arranged in such a manner that the low-density portions 92C are located nearer to the center of the rotating table 52. In that case, by turning on the line-like heating lamps 92, the wafer can heated with the zone-like temperature distribution as shown in Fig. 3. Then, after a predetermined temperature is reached, by turning on the line-like heating lamps 93 as well, the wafer can be heated with a uniform temperature distribution.

In the above embodiment, the stage 24 is divided into the three zones. However, the number of divided portions may be a free number of two or more. In addition, in the above embodiment, the stage 24 is divided into the concentriczones, but this invention . is not limited to this manner. For example, the stage may be divided into a plurality of circular spot-like zones. The heating unit is not limited to the heating lamps, but could be one or more resistance heater, which may be embedded in the stage.

Furthermore, this invention is applicable to not only the film-forming unit, but also an etching process, an oxidation-diffusion process, an annealing process or the like.

In addition, in the above embodiment, the semiconductor wafer is explained as an object to be processed. However, this invention is not limited thereto, but also applicable to a LCD substrate, a glass substrate and so on.

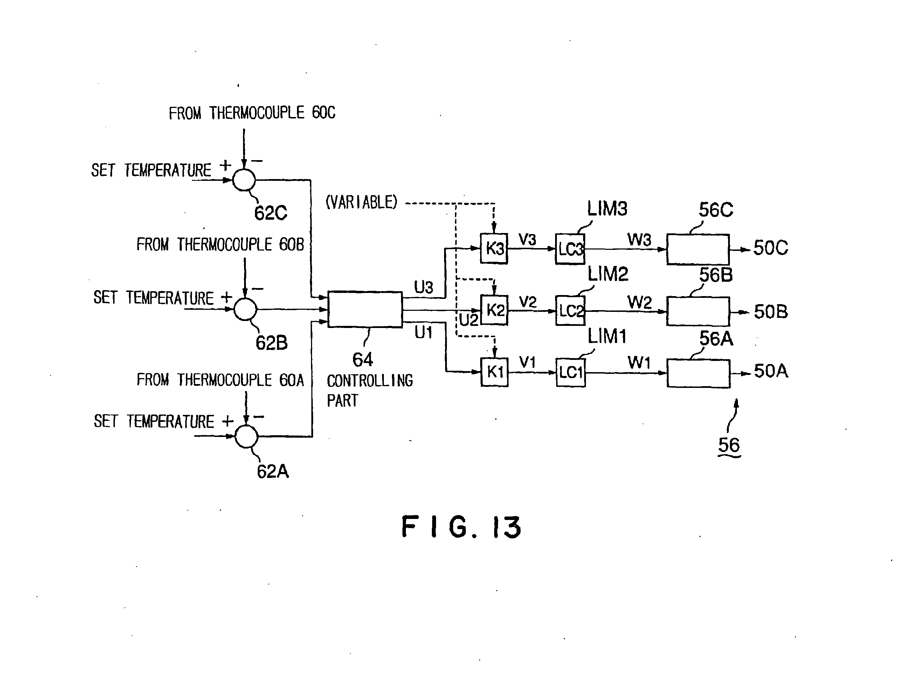

Nest, with reference to Fig. 13, another embodiment of the present invention is explained. Fig. 13 is ablock diagram showing an example of a control system of an electric-power controlling unit 58 of the embodiment. The electric-power controlling unit 58 of Fig. 13 is provided with limiting parts LIM1, LIM2 and LIM3 in order to limit actuating variables for the respective zones.

Hereinafter, regarding this embodiment, only parts different from the above embodiment are explained, that is, explanation of the same parts is omitted.

In Fig. 13, comparing parts 62A, 62B and 62C corresponding to the respective zones compare values of set temperatures for the respective zones and values measured by the respective thermocouples 60A to 60C, and output respective deviations. The controlling part 64 calculates respective actuating variables U1 U2 and U3 based on the respective deviations from the comparing parts 62A to 62C. Then, the respective actuating variables U1 to U3 outputted from the controlling part 64 are respectively multiplied by variable gain constants K1, K2 and K3 corresponding to the respective zones. Then, the outputs of the multiplication are limited by respective limiter constants LC1 to LC3, which have been predetermined at the respective limiter parts LIM1 to LIM3. The outputs are outputted to the respective electric-power supplying parts 56Ato 56C. That is, the respective limiting parts LIM1 to LIM3 function as fixed limiters. Herein, for example, if the gain constant K1 corresponding to the inside zone 24A is set to "1", the other gain constants K2 and K3 are respectively set to values not larger than "1" in advance in order to form the temperature distribution as shown in Fig. 3 and described above. If a value detected by the thermocouple 60A of the inside zone reaches the set temperature as the target temperature, the other gain constants K2 andK3 are also sequentially changed toward "1". Thus, finally, the temperature of the whole surface of the wafer can be maintained to the set temperature.

In addition, positive limiting constants LC1 to LC3, which are not larger than "1", are respectively set in the respective limiting parts LIM1 to LIM3. For example, values thereof may be set as LC1 - 0.9, LC2 = C2•LC1 and LC3 = C3•LC1. Herein, the C2 and C3 are averaging constants that have been predetermined so as to uniform balance of the electric power in the whole heating parts. That is, Cj (j is a positive integer) is a constant (averaging constant) determined in advance for each channel, regarding a rate between actuating variables for channels, in order to maintain the temperature distribution as shown in Fig. 3 even if an actuating variable for a channel is saturated.

Differently from the above fixed limiters, LC1 = 0.9 means for example the followings. That is, if an inputted actuating variable W1 for the electric-power supplying part 56A exceeds a thresholdvalue, the output is saturated. Assume that a threshold value is $W1_{sus}$ Then, assuming that an inputted actuating variable of the limiting part LIM1 is V1 and the outputted actuating variable is W1, if $V1 < 0.9 \cdot W1_{sus}$, the output of the limiting part is W1 = V1, but if $V1 \geq 0.9 \cdot W1_{sus}$, the output of the limiting part is $0.9 \cdot W1_{sus}$ independently of V1. That is, the limiting part has a function to clamp the outputted actuating variable to a value of (limiting constant) $\times Wi_{sus}$. The limiting process is conducted at the other limiting parts LIM2 and LIM3 as well.

If an actuating variable for a zone is saturated, balance of the amount of supplied heat may be lost, so that the temperature distribution during the heating process (see Fig. 3) may be not maintainedbutbroken down. However, by means of the above limiting process, the wafer can be surely heated while maintaining the temperature distribution as shown in Fig. 3, although the temperature-rising speed is a little lowered.

As described above, bymultiplying the respective actuating variables by the fixed limiting constants LC1 to LC3, it can be prevented that saturation of the actuating variables is generated, and thus the wafer can be heated as fast as possible without generating breakdown of the temperature distribution,

In addition, in the above embodiment, the thermocouples 60A to 60C are respectively provided for the respective zones 24A to 24C of the stage 24. However, this invention is not limited to this manner. For example, in order to measure a temperature distribution, only two thermocouples can be provided. For example, the thermocouples 60A and 60C may be respectively arranged for the inside zone 24A and the outside zone 24C. In the case, as a temperature of the middle zone 24B for using the temperature control, for example a median of values detected by the two thermocouples 60A and 60C can be used.

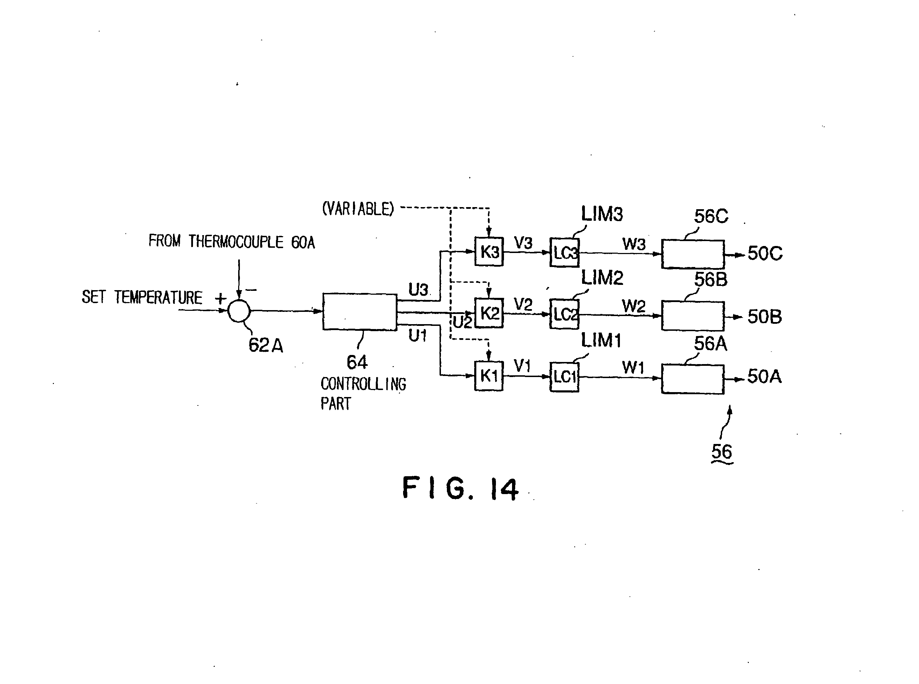

In addition, if only one thermocouple is provided for a zone, regarding the other zones, in order to generate the temperature distribution as shown in Fig. 3, electric power is supplied to the respective zones according to predetermined rates. Fig. 14 is a block diagram in conducting such a control, showing a case wherein the thermocouple 60A is provided only for the inside zone 24A. The controlling part 64 also determines the respective actuating variables U2 and U3 for the middle zone and the outside zone by calculation, based on the predetermined rates of electric power and a value detected by the thermocouple 60A.

In addition, in the embodiment, at the respective limiting parts LIM1 to LIM3, the actuating variables are limited by the always fixed limiting constants LC1 to LC3. However, this invention is not limited thereto. For example, when the wafer is heated, if an actuating variable for a zone is saturated, in order to compensate for this, the limiter values of the other zones may be multiplied by a variable control value to limit the final outputted actuating variables. That is, the limiting parts may be function as not the fixed limiters but variable limiters. Thus, if an actuating variable is saturated, the wafer can be heated while maintaining the temperature distribution as shown in Fig. 3.

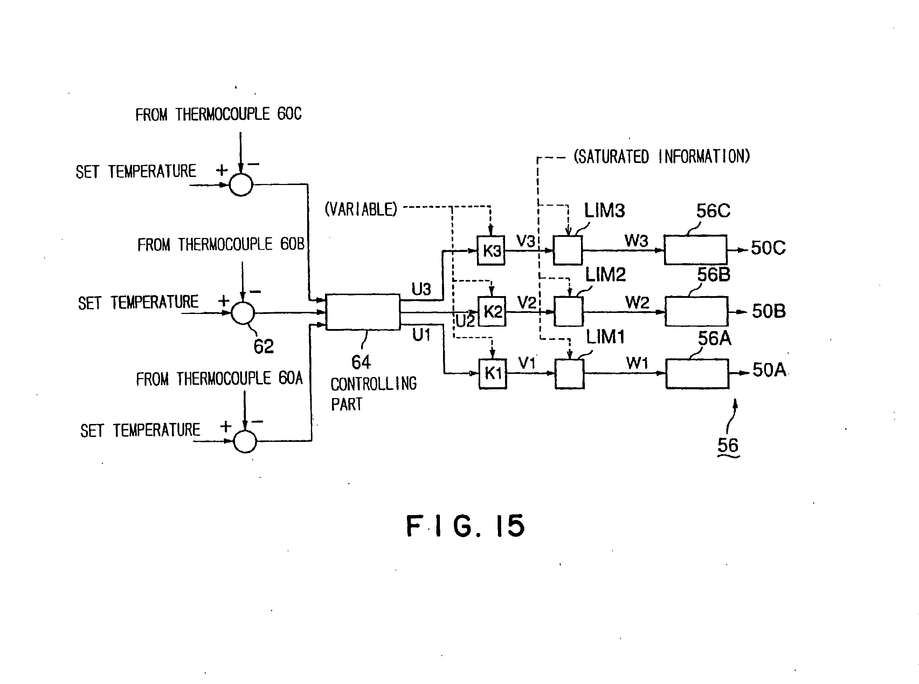

Fig. 15 is a block diagram showing an example of a control system of the electric-power controlling unit 58 for conducting such a control.

The controlling part 64 in the drawings calculates the actuating variables for the three channels corresponding to the respective zones. At that time, assume that a channel whose actuating variable is saturated is "i" channel, that an inputted actuating variable of LIMi based on a control calculation is Vi, and that an inputted actuating variable when an electric-power supplying part 56i is landed with a saturation is $Wi_{sus}$. Then, a ratio Li of the both actuating variables is defined as the following equation.

$$Li = Vi / Wi_{sus}$$

Then, based on the above ratio Li, the limiting values LCj of the other channels which generate no saturation are calculated by the following equation. Thesevaluesaresentaslimitingvalues to the limiting parts of the other channels than the channel which generates the saturation.

$$LCj = (Cj / Li) \times (Vj / Wj_{sus})$$

Herein, as described above, the Cj is an averaging constant that has been predetermined so as to average the electric power for the respective channels.

According to the above calculation, if an actuating variable of the channel for the inside zone is saturated, the respective limiting values are as the following table.

Hererin, LC1 = 1, and the clamped outputted actuating variables at the respective zones are given by ($LC_j \times W_{j_{sus}}$).

| | Limiting value LCj | Limiter output | |
|---|---|---|---|
| | | Clamp on | Clamp off |
| Inside zone | 1 | $W1_{sus}$ | V1 |
| Middle zone | $(C2/L1) \times (V2/W2_{sus})$ | $V2 \times 2/L1$ | V2 |
| Outside zone | $(C3/L1) \times (V3/W3_{sus})$ | $V3 \times C3/L1$ | V3 |

That is, if an actuating variable for a zone is landed with a saturation, actuating variables for the other channels which generate no saturation are dynamically limited based on information from the channel which generates the saturation. Thus, even if an actuating variable for a zone generates a saturation, the outputted actuating variables for the respective channels are maintained suitably. Thus, the wafer can be heated while more accurately maintaining the temperature distribution as shown in Fig. 3, and thus it can be surely prevented that a cockup (cambering) of the wafer is generated.

In addition, in the above explanation, as a concept of limiter, it is explained that the actuating variable Wj is clamped. However, this invention is not limited to this manner. For example, in a case of a fixed limiter, a fixed limiting constant may be common for all the zones, and inputted actuating variables Vj may be always multiplied by the limiting constant in order not to saturate the outputs.

Furthermore, in a case of a variable limiter, if an actuating variable for a zone is saturated, actuating variables for the other zones may be limited immediately, and without waiting that the actuating variables are clamped.

**Claims**

**1.** A thermal processing method comprising:

a placing step of placing an object to be processed onto a stage arranged in a processing container that can be vacuumed, and
a heating step of heating the object to be processed to a predetermined temperature,

wherein the object to be processed is heated under a state in which a temperature distribution is maintained in such a manner that a temperature at a central portion of the object to be processed is high while a temperature at a peripheral portion of the object to be processed is low, during at least a part of the heating step.

**2.** A thermal processing method according to claim 1, wherein
the object to be processed is heated with a temperature-rising speed that is slower than a heat-transferring speed from the central portion to the peripheral portion of the object to be processed, during at least a part of the heating step.

**3.** A thermal processing method according to claim 1, wherein
the predetermined temperature is a cockup-safe temperature at which a coefficient of thermal expansion of the object to be processed is so low that it is difficult for the object to be processed to cock up.

**4.** A thermal processing method comprising:

a placing step of placing an object to be processed onto a stage arranged in a processing container that can be vacuumed, and
a heating step of heating the object to be processed to a predetermined temperature,

wherein a pressure in the processing container is set equal to or lower than a viscous flow, during at least a part of the heating step.

5. A thermal processing method according to claim 4, wherein
    the pressure equal toor lower than a viscous flow corresponds to a pressure not more than 133 Pa (1 Torr).

6. A thermal processing method according to claim 4, wherein
    the predetermined temperature is a cockup-safe temperature at which a coefficient of thermal expansion of the object to be processed is so low that it is difficult for the object to be processed to cock up.

7. A thermal processing unit comprising:

    a processing container that can be vacuumed,
    a stage arranged in the processing container, on which an object to be processed is placed,
    a plurality of zone-heating parts that independently heat respective concentrically divided zones of the object to be processed,
    an electric-power supplying unit that supplies electric power to each of the plurality of zone-heating parts,
    a temperature measuring unit provided correspondingly to at least one of the zones of the object to be processed, and
    an electric-power controlling unit that controls the electric-power supplying unit based on a value detected by the temperature measuring unit in such a manner that the object to be processed is heated to a predetermined temperature under a state in which a temperature distribution is maintained wherein a temperature at a central portion of the object to be processed is high while a temperature at a peripheral portion of the object to be processed is low.

8. A thermal processing unit comprising:

    a processing container that can be vacuumed,
    a stage arranged in the processing container, on which an object to be processed is placed,
    a heating part that heats the object to be processed in such a manner that a predetermined temperature distribution is formed,
    an electric-power supplying unit that supplies electric power to the heating part, and
    an electric-power controlling unit that controls the electric-power supplying unit in such a manner that the object to be processed is heated to a predetermined temperature under a state in which a temperature distribution is maintained wherein a temperature at a central portion of the object to be processed is high while a temperature at a peripheral portion of the object to be processed is low.

9. A thermal processing unit comprising:

    a processing container that can be vacuumed,
    a stage arranged in the processing container, on which an object to be processed is placed,
    a heating part that heats the object to be processed in such amanner that a concentric temperature distribution is formed,
    an electric-power supplying unit that supplies electric power to the heating part,
    a temperature measuring unit provided correspondingly to at least one position of the object to be processed, and
    an electric-power controlling unit that controls the electric-power supplying unit based on a value detected by the temperature measuring unit in such a manner that the object to be processed is heated to a predetermined temperature under a state in which a temperature distribution is maintained wherein a temperature at a central portion of the object to be processed is high while a temperature at a peripheral portion of the object to be processed is low.

10. A thermal processing unit comprising:

    a processing container that can be vacuumed,
    a stage arranged in the processing container, on which an object to be processed is placed,
    a plurality of zone-heating parts that independently heat respective concentrically divided zones of the object to be processed,
    an electric-power supplying unit that supplies electric power to each of the plurality of zone-heating parts,
    a power detecting unit that detects respective power supplied from the electric-power supplying unit to the respective zone-heating parts or respective power emitted from the respective zone-heating parts, and

an electric-power controlling unit that controls the electric-power supplying unit based on a value detected by the power detecting unit in such a manner that the object to be processed is heated to a predetermined temperature under a state in which a temperature distribution is maintained wherein a temperature at a central portion of the object to be processed is high while a temperature at a peripheral portion of the object to be processed is low.

11. A thermal processing unit comprising:

a processing container that can be vacuumed,
a stage arranged in the processing container, on which an object to be processed is placed,
a heating part that heats the object to be processed in such amanner that a concentric temperature distribution is formed,
an electric-power supplying unit that supplies electric power to the heating part,
a power detecting unit that detects power supplied from the electric-power supplying unit to the heating part or power emitted from the heating part, and
an electric-power controlling unit that controls the electric-power supplying unit based on a value detected by the power detecting unit in such a manner that the object to be processed is heated to a predetermined temperature under a state in which a temperature distribution is maintained wherein a temperature at a central portion of the object to be processed is high while a temperature at a peripheral portion of the object to be processed is low.

12. A thermal processing unit according to claim 10 or 11, wherein
the power detecting unit includes at least one of a current detector, a voltage detector and a light-quantity detector.

13. A thermal processing unit according to any of claims 7 to 12, wherein
the predetermined temperature is a cockup-safe temperature at which a coefficient of thermal expansion of the object to be processed is so low that it is difficult for the object to be processed to cock up.

14. A thermal processing unit according to any of claims 7 to 12, wherein
the predetermined temperature is a temperature not lower than 300 °C.

15. A thermal processing unit according to any of claims 7 to 14, wherein
the electric-power controlling unit can control the electric-power supplying unit in such a manner that the object to be processed is heated with a temperature-rising speed that is slower than a heat-transferring speed from the central portion to the peripheral portion of the object to be processed.

16. A thermal processing unit according to any of claims 7 to 15, wherein
the electric-power controlling unit includes a limiter part for limiting an actuating variable.

17. A thermal processing unit according to claim 16, wherein
the limiter part is adapted to conduct a limiting process to the actuating variable with a fixed limiter-constant in such a manner that the actuating variable is not saturated while the object to be processed is heated.

18. A thermal processing unit according to claim 16, wherein
the limiter part is adapted to conduct a limiting process to the actuating variable with a variable limiter-value in such a manner that the actuating variable is not saturated while the object to be processed is heated.

19. A thermal processing unit according to claim 7 or 10, wherein
the electric-power controlling unit includes a plurality of limiter parts for limiting actuating variables to the respective zone-heating parts, and
when an actuating variable to a zone-heating part is saturated, the respective limiter parts are adapted to conduct a limiting process to actuating variables to the other zone-heating parts.

20. A thermal processing unit according to claim 19, wherein
a limiter-value used for the limiting process is determined based on a ratio between an actuating variable to the saturated zone-heating part and the saturated actuating variable to the saturated zone-heating part.

FILM-FORMING GAS

12

FROM TEMPERATURE MEASURING UNIT 60
(THERMOCOUPLES 60A ~ 60C)

58
ELECTRIC-POWER
CONTROLLING UNIT

F I G. I

24A
24B
24C
24
24
60
60A
60C
60B
50C
50B
50A 50B
50C
50
56C
56B
56A
56
58
ELECTRIC-POWER
CONTROLLING UNIT

FIG. 2

FIG. 3

FIG. 4

EP 1 367 637 A1

(VARIABLE) ----------

FROM THERMOCOUPLE 60A

LC    56C

K3    LC    50C

56B

SET TEMPERATURE +  −

K2    LC    50B

62

64
CONTROLLING
PART

K1    LC    50A

56A

56

F I G. 5

**FIG. 6**

FIG. 7

FIG. 8

(A)

W

(B)

W

W

W

# FIG. 9

90

92

92C

92B

92A

92C 92B 92A

92A
92B 92C

90

90

92

92A

92B

92

52

92

92C

90

# FIG. 10

F I G. 11

F I G. 12

EP 1 367 637 A1

FROM THERMOCOUPLE 60C

SET TEMPERATURE $+$ $-$

62C

(VARIABLE)

LIM3

56C

FROM THERMOCOUPLE 60B

SET TEMPERATURE $+$ $-$

62B

64
CONTROLLING
PART

U3

K3

V3

LC3

W3

50C

56B

LIM2

U2

K2

V2

LC2

W2

50B

U1

LIM1

56A

FROM THERMOCOUPLE 60A

SET TEMPERATURE $+$ $-$

62A

K1

V1

LC1

W1

50A

56

F I G. 13

FIG. 14

FROM THERMOCOUPLE 60C

SET TEMPERATURE

FROM THERMOCOUPLE 60B

SET TEMPERATURE

FROM THERMOCOUPLE 60A

SET TEMPERATURE

62

64
CONTROLLING
PART

(VARIABLE)

(SATURATED INFORMATION)

LIM3
56C
K3 V3 W3 50C

LIM2
56B
U3
U2 K2 V2 W2 50B
U1
LIM1
56A
K1 V1 W1 50A

56

F I G. 15

FIG. 16

FIG. 17

F I G. 18

## INTERNATIONAL SEARCH REPORT

| International application No. |
| --- |
| PCT/JP02/01380 |

| A. CLASSIFICATION OF SUBJECT MATTER |
| --- |
| Int.Cl⁷ H01L21/26 |

According to International Patent Classification (IPC) or to both national classification and IPC

| B. FIELDS SEARCHED |
| --- |
| Minimum documentation searched (classification system followed by classification symbols) |
| Int.Cl⁷ H01L21/26-21/268, H01L21/322-21/326, H01L21/205, H01L21/31 |

Documentation searched other than minimum documentation to the extent that such documents are included in the fields searched

| Jitsuyo Shinan Koho | 1922-1996 | Toroku Jitsuyo Shinan Koho | 1994-2002 |
| Kokai Jitsuyo Shinan Koho | 1971-2002 | Jitsuyo Shinan Toroku Koho | 1996-2002 |

Electronic data base consulted during the international search (name of data base and, where practicable, search terms used)

| C. DOCUMENTS CONSIDERED TO BE RELEVANT | | |
| --- | --- | --- |
| Category* | Citation of document, with indication, where appropriate, of the relevant passages | Relevant to claim No. |
| X <br> Y | JP 62-20308 A (Hitachi, Ltd.), <br> 28 January, 1987 (28.01.87), <br> Full text; Figs. 1 to 3 (Family: none) <br> Full text; Figs. 1 to 3 (Family: none) | 1,3,7-14 <br> 2,15-20 |
| X | JP 2-249227 A (NEC Corp.), <br> 05 October, 1990 (05.10.90), <br> Full text; Figs. 1 to 3 <br> (Family: none) | 4-6 |
| Y | Noboru AKIYAMA, et al., "Critical Radial Temperature Gradient Inducing Slip Dislocations in Silicon Epitaxy Using Dual Heating of the Two Surfaces of a Wafer", Jpn. J. Appl. Phys., Vol.25, No.11, 20 November, 1986 (20.11.86), Pages 1619 to 1622 | 2,15 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 10 May, 2002 (10.05.02) | 21 May, 2002 (21.05.02) |

| Name and mailing address of the ISA/ <br> Japanese Patent Office | Authorized officer |
| --- | --- |
| Facsimile No. | Telephone No. |

Form PCT/ISA/210 (second sheet) (July 1998)

**EP 1 367 637 A1**

## INTERNATIONAL SEARCH REPORT

International application No.

PCT/JP02/01380

C (Continuation).  DOCUMENTS CONSIDERED TO BE RELEVANT

| Category* | Citation of document, with indication, where appropriate, of the relevant passages | Relevant to claim No. |
|---|---|---|
| Y | JP 7-316811 A  (Hitachi, Ltd.),<br>05 December, 1995 (05.12.95),<br>Full text; Figs. 1 to 6<br>(Family: none) | 16-20 |
| A | US 5445675 A  (Tel-Varian Ltd.),<br>29 August, 1995 (29.08.95),<br>Full text; Figs. 1 to 10<br>& JP 6-224135 A<br>Full text; Figs. 1 to 7<br>& JP 6-163419 A<br>Full text; Figs. 1 to 4<br>& KR 241291 B1 | 1-20 |
| A | JP 3-218624 A  (Nippon Soken, Inc.),<br>26 September, 1991 (26.09.91),<br>Full text; Figs. 1 to 33<br>(Family: none) | 1-20 |
| A | JP 2000-193375 A  (Dainippon Screen Mfg. Co.,<br>Ltd.),<br>14 July, 2000 (14.07.00),<br>Full text; Figs. 1 to 19<br>(Family: none) | 1-20 |
| A | JP 6-333846 A  (Canon Inc.),<br>02 December, 1994 (02.12.94),<br>Full text; Figs. 1 to 4<br>(Family: none) | 4-6 |

Form PCT/ISA/210 (continuation of second sheet) (July 1998)